# EUROPEAN PATENT APPLICATION

(11) **EP 1 731 966 A1**
(43) Date of publication of application: **13.12.2006**
(21) Application number: 05727502.6
(22) Date of filing: 28.03.2005
(51) Int. Cl.: G03F 7/20, H01L 21/027, G11B 7/26

(54) **EXPOSURE EQUIPMENT**

(30) Priority: 30.03.2004 JP 2004097471
(71) Applicant: Pioneer Corporation, Tokyo 153-8654 (JP)
(72) Inventor: KASONO, Osamu; Corporate R & D Laboratories, Tsurugashima-shi, Saitama; 3502288 (JP); KUMASAKA, Osamu; Corporate R & D Laboratories, Tsurugashima-shi, Saitama; 3502288 (JP); HOSODA, Yasuo, c/o Corporate R & D Laboratories, Tsurugashima-shi, Saitama; 3502288 (JP)
(74) Representative: Goddar, Heinz J.
(86) International application number: PCT/JP2005/006525
(87) International publication number: WO 2005/096101

(57) **Abstract**

The device includes a substrate holding portion for holding a substrate having resist formed thereon, a driving portion for varying the irradiation position of an exposure beam relatively to the substrate, and a cooling portion for cooling the substrate during irradiation of the exposure beam.

## Description

### Technical Field

The present invention relates to an exposure device, and particularly to an exposure device for carrying out exposure while moving the irradiation position of an exposure beam onto a substrate on which a resist is formed.

### Background Art

A method using a chemical amplification type resist having high sensitivity and high resolution is used is known as a method of forming a fine pattern. According to the patterning method, exposure (drawing) using an electron beam, post-exposure bake (PEB: Post Exposure Bake) and development are carried out on a substrate coated with a chemical amplification resist. A predetermined time is needed from the drawing step till the PEB step, and the size of a pattern achieved after the development is varied between a portion drawn at the initial stage of drawing and a portion drawn at the last stage on the same substrate. This is caused by a phenomenon that the time required from the drawing step till the PEB step (post-exposure delay time or standby time) is varied in accordance with the position on the substrate and thus the same reaction as PEB progresses during the standby time. Furthermore, when a sheet-feed type treatment is carried out, the size of a pattern achieved after the development is varied in accordance with the treatment order of the substrate, for example, between the first drawn (or developed) substrate and the last drawn (or developed) substrate.

The above-described problem is known as a PED (Post Exposure Delay) problem to the chemical amplification resist or the like. The development of resists has been continued to suppress the effect of the standby time as described above, however, a sufficient development has not yet been achieved.

Furthermore, as a method of solving the problem are disclosed a method of controlling the PEB condition on the basis of the time from the drawing step to the PEB step and the standby time characteristic of the resist (see, Japanese Laid-Open Patent Application Kokai No.08-111370) and a method of cooling the substrate to suppress the reaction during the period after the drawing step till the development step (see, Japanese Laid-Open Patent Application Kokai No.10-172882).

However, for example, when drawing is carried out by using an electron beam, it takes much time to drawn the whole surface of the substrate, and the reaction progresses during the drawing time. For example, it takes about three hours to draw the whole surface of a disc of 120mm in diameter by using a chemical amplification resist. Furthermore, the electron beam is irradiated to the drawing substrate with energy of several KeV to 100kev, for example. In general, the resolution of the electron beam is dependent on the energy of the electron beam, and a high-energy electron beam is used when high resolution is achieved. A part of the energy of the electron beam is used for the exposure reaction of the resist. However, most of the other energy is converted to heat by scattering in the substrate, and the substrate is locally heated. Therefore, the reaction during the standby time is promoted by the heat.

Accordingly, the related art described above has a problem that PED cannot be sufficiently controlled. Furthermore, the method of adjusting the PEB condition or the like has a drawback that the adjusting method and the adjusting condition are complicated and bothersome.

### DISCLOSURE OF THE INVENTION

The present invention has been made in view of the foregoing problems, and has an object to provide an inexpensive exposure device that can suppress PED (Post Exposure Delay) and achieve an excellently uniform pattern.

In order to attain the above object, according to the present invention, an exposure device for irradiating an exposure beam to a substrate having a resist formed thereon to form a latent image on the resist is characterized by comprising a substrate holder for holding the substrate, a driving portion for relatively changing the irradiation position of the exposure beam to the substrate, and a cooling portion for cooling the substrate during the irradiation of the exposure beam.

According to the present invention, an exposure device for irradiating an exposure beam to a substrate having a resist formed thereon to form a latent image is characterized by comprising a substrate holding portion for holding the substrate; a spindle for rotating the substrate holding portion; a fluid bearing portion for holding the spindle; and a conduit pipe that passes through the fluid bearing portion and the spindle to supply cooling fluid to the substrate holding portion.

According to the present invention, an exposure device for irradiating an exposure beam to a disc-shaped substrate having a resist formed thereon to form a latent image on the resist is characterized by comprising a substrate holding portion for holding the substrate and rotating the substrate, an irradiation portion for irradiating the exposure beam to the substrate; and a low temperature member that is disposed above the substrate and at the rotational downstream side of the irradiation position of the exposure beam.

### BRIEF DESCRIPTION OF THE DRAWINGS

Fig. 1 is a block diagram showing the configuration of an electron beam exposure device according to a first embodiment of the present invention;
Fig. 2 is a diagram showing a cooling heat pipe provided in a turntable;
Fig. 3 is a block diagram showing the configuration of an exposure device according to a second embodiment of the present invention;
Fig. 4 shows a modification of the second embodiment as shown in Fig. 3 and is a diagram showing a case where an air blower for cooling the substrate from the back surface side;
Fig. 5 is a block diagram showing the configuration of an exposure device according to a third embodiment of the present invention;
Fig. 6 is a block diagram showing the configuration of an exposure device according to a modification of the third embodiment of the present invention;
Fig. 7 is a diagram showing the configuration of a substrate rotating portion of an electron beam exposure device according to a fourth embodiment of the present invention;
Fig. 8 is a cross-sectional view showing the detailed structures of a bearing and a spindle;
Fig. 9 is a cross-sectional view showing the structure taken along A-A line of Fig. 8;
Fig. 10 is a cross-sectional view showing the structure taken along B-B line of Fig. 8;
Fig. 11 is a block diagram showing the configuration of a substrate rotating portion of an electron beam exposure device according to a fifth embodiment of the present invention;
Fig. 12 is a block diagram showing the configuration of a substrate rotating portion of an electron beam exposure device according to a sixth embodiment of the present invention;
Fig. 13 is a block diagram showing the configuration of the substrate rotating portion of the electron beam exposure device according to the sixth embodiment of the present invention;
Fig. 14 is a top view showing the arrangement of a substrate and a low temperature member; and
Fig. 15 is a top view showing the arrangement of the substrate and the low temperature member.

### EMBODIMENTS FOR CARRYING OUT THE INVENTION

Embodiments according to the present invention will be described in detail. In the following embodiments, the equivalent constituent elements are represented by the same reference numerals.

### [First Embodiment]

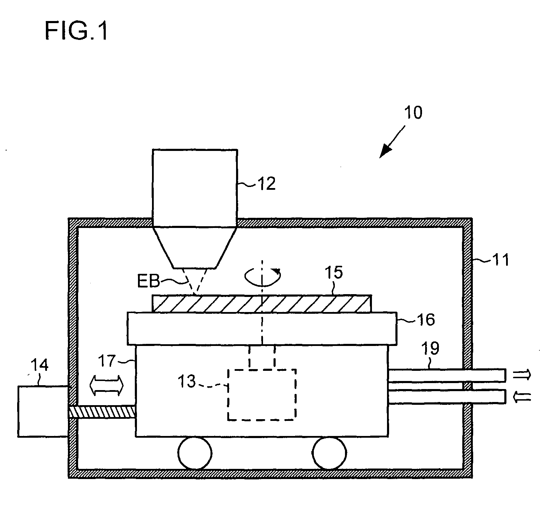

Fig. 1 is a block diagram showing the configuration of an electron beam exposure device 10 according to a first embodiment of the present invention. The electron beam exposure device 10 is a mastering device for creating a master disc such as a magnetic disc or an optical disc by using an electron beam.

The electron beam exposure device 10 is equipped with a vacuum chamber 11, an electron beam column 12 secured to the vacuum chamber 11, driving devices 13, 14 for rotating and translating a substrate disposed in the vacuum chamber 11, various kinds of circuits for controlling the driving of the substrate, controlling the electron beam, etc., and a control system (not shown).

More specifically, the substrate 15 for the disc master is mounted on a turntable 16. The turntable 16 is provided on a rotating and feeding stage (hereinafter, simply referred to as stage) 17. The stage 17 has a spindle motor 13 for rotating the turntable 16 on which the substrate 15 is mounted. The stage 17 is coupled to a feeding motor 14 for translating the turntable 16. Accordingly, the substrate 15 can be moved in a predetermined direction in a plane parallel to the principal surface of the substrate 15 while rotating the substrate 15. The turntable 16 may be equipped with an electrostatic chucking mechanism for holding the substrate 15 while chucking the substrate 15. Alternatively, the turntable 16 may be equipped with a configuration of mechanically pressing the substrate 15 so that the substrate 15 is in close contact with the turntable 16.

The electron beam column 12 is provided with an electron gun (emitter) for emitting an electron beam, a lens for converging the electron beam, and an electrode, a coil, etc. (not shown) for deflecting the electron beam. An electron beam (EB) of electron beam current of several nA to several 100nA which is converged by an objective lens to have an energy of several KeV to several tens KeV is irradiated to the resist on the substrate 15. For example, the acceleration voltage of electrons being used is 50kV, and the electron beam current is set to 120nA.

If the electron beam current or the like is intensified, the exposure (drawing) can be finished in a shorter time. However, the heating of the irradiation of the electrode beam is increased, and thus the reactivity of the resist is enhanced.

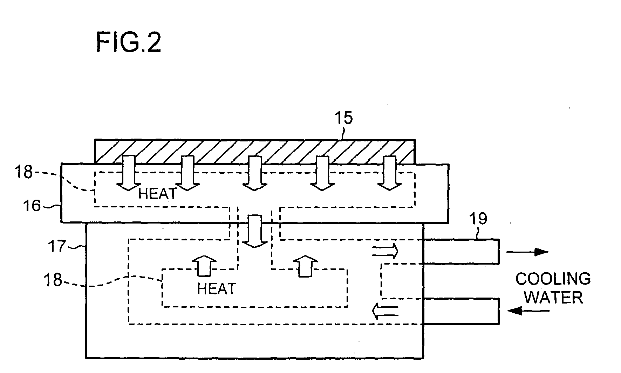

As shown in Fig. 2, a water cooling type cooling device 18 is provided in the turntable 16. More specifically, the cooling device 18 is a heat pipe 18 (indicated by a broken line in Fig. 2) which is piped in the stage 17. Cooling medium such as cooling water or the like is supplied from the outside through the conduit pipe 19 is supplied to the heat pipe 18, whereby the turntable 16, that is, the substrate 15 can be cooled even during the exposure of the electron beam. In Fig. 2, arrows in the turntable 16 and the stage 17 indicate flow of heat. Accordingly, local heating of the substrate 15 due to irradiation of the electron beam can be avoided. The cooling of the substrate 15 described above is performed during at least the exposure period.

Accordingly, the reaction of the resist during execution of the drawing (i.e. , electron beam exposure) on the substrate 15 can be suppressed, and PED can be sufficiently suppressed. Particularly, this effect is enhanced when an electron beam having high energy is used or electron beam current is increased, and the reaction of the resist can be effectively suppressed. Furthermore, since it is sufficient only to cool the substrate 15, and thus it is unnecessary to perform complicated and bothersome adjustment.

### [Second Embodiment]

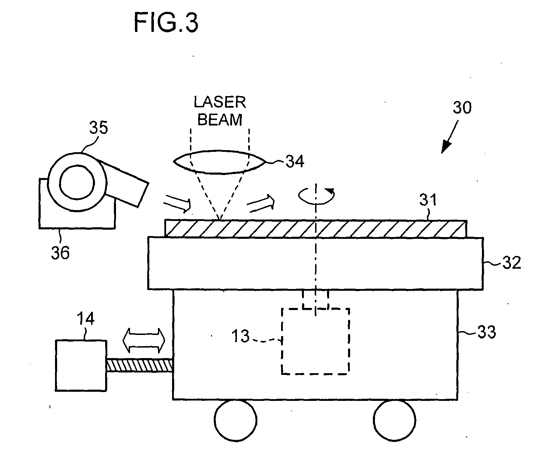

Fig. 3 is a block diagram showing the configuration of an exposure device 30 according to a second embodiment of the present invention. The exposure device 30 is a device for creating a master disc such as an optical disc or the like by using a laser light beam, for example.

In the exposure device 30, a substrate 31 for a mater disc is mounted on a turntable 32. The turntable 32 is provided on a stage 33. The exposure device 30 has a spindle motor 13 for rotating the turntable 32 on which the substrate 31 is mounted, and a feeding motor 14 for translating the turntable 32, whereby the substrate 31 can be moved in a predetermined direction in a plane parallel to the principal surface of the substrate 31 while rotating the substrate 31. The exposure device 30 has an optical system for condensing a laser beam for beam exposure and irradiating the laser beam on the substrate 31. That is, the laser beam is condensed by an objective lens 34, and the beam spot of the laser beam is irradiated onto a resist coated on the substrate 31 to perform beam exposure.

The exposure device 30 is provided with an air blower (blower) 35. The air blower 35 is designed to cool the turntable, that is, the substrate 31 even during exposure (drawing) operation. The orientation of the air blower 35 is settled so that air (air or cooled air) from the air blower 35 impinges against the surface of the substrate 31. As shown in Fig. 3, the air blower 35 is preferably secured to a moving device 36 which can adjust the orientation of the air blower 35. The orientation of the air blower 35 is adjusted so that the air blown from the air blower 35 impinges against the irradiation position of the laser beam on the substrate 31

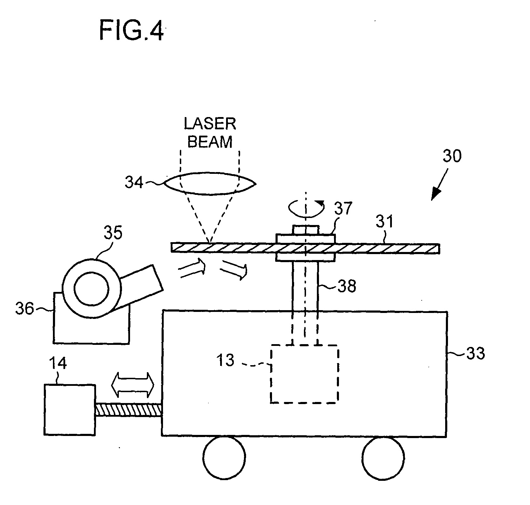

Next, a modification of the embodiment will be described with reference to Fig. 4.

The substrate 31 is partially held at only the center portion thereof by a substrate holder (chucking) 37, and fixed to the upper portion of a rotational shaft 38 of the spindle motor 13. This modification is the same as the above embodiment in that the substrate 31 can be moved in a predetermined direction in a plane parallel to the principal surface of the substrate 31 with rotating the substrate 31 by the spindle motor 13 and the feeding motor 14.

The exposure device 30 is provided with an air blower (blower) 35. The air blower 35 cools the substrate 31 from the back surface (the surface at the opposite side to the exposure surface of the substrate 31) of the substrate 31. The air blower 35 is secured to the moving device 36 that can adjust the orientation of the air blower 35, and the orientation of the air blower 35 is adjusted so that the air blown from the air blower 35 impinges the back surface position of the substrate 31 corresponding to the irradiation position of the laser beam.

Accordingly, the heating of the substrate 31 is suppressed, so that the reaction of the resist during the execution of the drawing (exposure) of the substrate 31 is suppressed, and PED can be sufficiently suppressed. Furthermore, since it is sufficient only to cool the substrate 31, it is unnecessary to perform complicated and bothersome adjustment.

### [Third Embodiment]

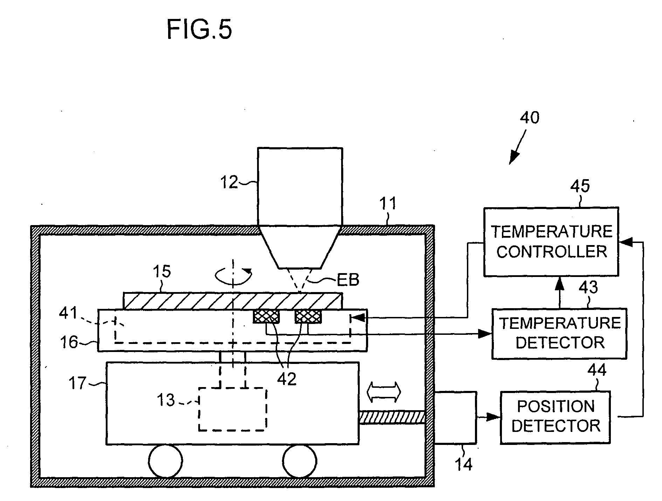

Fig. 5 is a block diagram showing the configuration of an electron beam exposure device 40 according to a third embodiment. The electron beam exposure device 40 is a mastering device for creating a master disc such as a magnetic disc, an optical disc or the like by using an electron beam, for example.

The electron beam exposure device 40 is provided with a vacuum chamber 11, a driving device that is disposed in the vacuum chamber and rotates and translates a substrate while the substrate is disposed thereon, an electron beam column 12 secured to the vacuum chamber 11, various kinds of circuits for controlling the driving of the substrate, the electron beam, etc., and a control system (not shown).

More specifically, the substrate 15 for the disc master is put on the turntable 16. The turntable 16 is provided on the stage 17. The stage 17 has a spindle motor 13 for rotating the turntable 16 mounted on the substrate 15. The stage 17 is coupled to a feeding motor 14 for translating the turntable 16. Accordingly, the substrate 15 can be moved in a predetermined direction in a plane parallel to the principal surface of the substrate 15 while rotating the substrate 15. The turntable 16 is provided with a mechanism for chucking the substrate 15 so that the substrate 15 is brought into close contact with the turntable 16.

As shown in Fig. 5, a cooling device 41 (indicated by a broken line in Fig. 5) that can electrically cool the substrate 15 (turntable 16) is provided in the turntable 16. For example, a Peltier cooling device containing a Peltier element may be used as the cooling device 41. The description will be made by exemplifying a case where a Peltier cooling device 41 containing a Peltier element is used as the cooling device 41. Furthermore, a temperature sensor 42 having at least one detecting element such as a thermistor or the like is provided to detect the temperature of the substrate 15. In this embodiment, the temperature sensor 42 has a plurality of detecting elements which are arranged in the radius (radial) direction of the substrate 15 in the turntable 16 so that the in-plane temperature distribution of the substrate 15 can be detected.

A detection signal from the temperature sensor 42 is supplied to a temperature signal generator 43. The temperature signal generator 43 generates a temperature signal representing the temperature of the substrate 15 on the basis of the temperature detection signal concerned and transmits the temperature signal to a temperature controller 45. A position detector 44 generates an irradiation position signal representing the position on the substrate 15 to which the electron beam is irradiated, and transmits it to the temperature controller 45. For example, the feeding motor 14 is a stepping motor, and the position detector 44 detects the beam irradiation position (the position in the radial direction) with respect to a reference position (for example, the center of the substrate) on the basis of the number of stepping pulses of the feeding motor 14.

The temperature controller 45 controls the cooling device 41 on the basis of the temperature detection signal and the irradiation position signal to cool the portion corresponding to the beam irradiation position at the back side of the substrate 15 locally and intensively. For this purpose, the cooling device 41 is divided into a plurality of cooling portions. For example, the cooling device 41 comprises plural Peltier elements arranged concentrically, and the Peltier element located at the radial position corresponding to the beam irradiation position is driven to cool the substrate 15. Accordingly, this effect is greater particularly when large electron beam current is used and the heating of the substrate 15 (resist) is locally increased, and the reaction of the resist can be effectively suppressed.

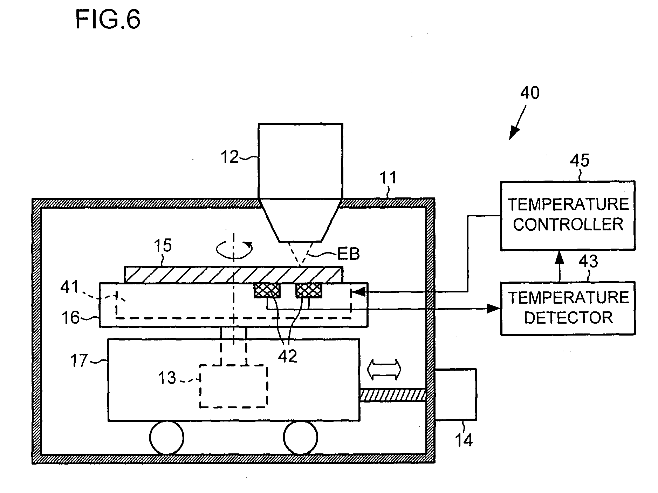

Alternatively, as a modification of the embodiment, the temperature controller 45 may control the cooling device 41 merely on the basis of the temperature detection signal to uniformly cool the substrate 15 as shown in Fig. 6. Accordingly, in this case, no position detector 44 may be provided. For example, the substrate 15 is cooled so that the temperature thereof is equal to a predetermined temperature (for example, room temperature) or less.

It is preferable that the cooling operation of the substrate 15 is executed during at least the exposure period.

As various embodiments are described above, by cooling the substrate during execution of the drawing (exposure) operation, the reaction of the resist can be lowered, and PED can be sufficiently suppressed. The effect is particularly large when an electron beam having high energy is used or the electron beam current is increased to enhance the resolution, and the reaction of the resist can be effectively suppressed. Furthermore, there can be implemented an exposure device in which it is unnecessary to perform complicated and bothersome adjustment and a pattern having excellent uniformity can be easily achieved.

The above-described embodiments may be properly combined with one another. For example, in the first embodiment, a cooling device using a Peltier element or the like may be sued in place of the cooling device using cooling water.

Furthermore, the above-described embodiments relate to an exposure device using a so-called X-θ stage. However, the present invention is not limited to this embodiment, and each of the embodiments may relate to an X-Y type exposure device.

### [Fourth Embodiment]

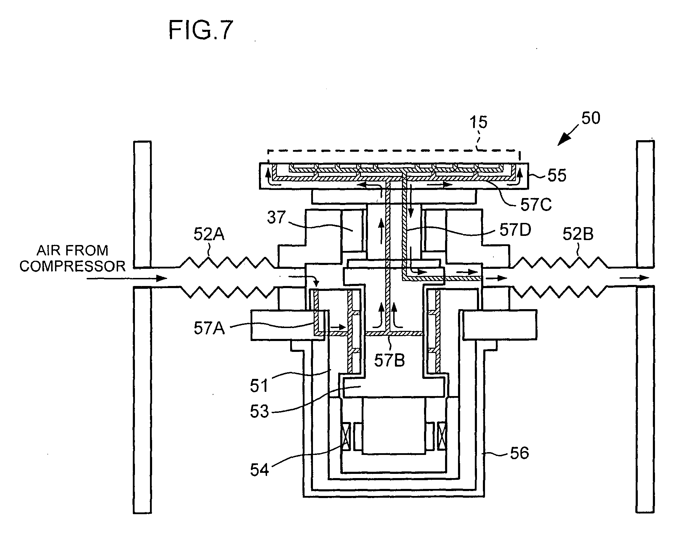

Fig. 7 is a block diagram showing the configuration of a substrate rotating portion of the electron beam exposure device 10 according to a fourth embodiment of the present invention. An air bearing (air bearing) mechanism is used as a rotational bearing of the substrate rotating portion concerned. In the following description, the bearing portion will be referred to as air bearing or bearing. The configuration other than the configuration relating to the substrate rotating portion is the same as the electron beam exposure device 10 of the first embodiment, etc.

More specifically, pressurized air from an air compressor (not shown) is supplied to the air bearing 51 through an air conduit pipe 52A at the introduction side. A spindle 53 is floated and held by the pressurized air, and a spindle shaft (hereinafter simply referred to as spindle) 53 is rotated by the spindle motor 54. The turntable 55 secured to the spindle 53 is rotated by rotation of the spindle 53, and the substrate 15 for the disc master mounted on the turntable 55 is rotated. 56 represents a steel cover.

In the embodiment, air from the air compressor is supplied to the turntable 55 through the air bearing 51 and the spindle 53. More specifically, a part of the pressurized air supplied from the air-compressor to the air bearing (hereinafter simply referred to as bearing) 51 is supplied to the turntable 55 through a conduit pipe 57A provided in the bearing 51 and a conduit pipe 57B provided in the spindle 53. The air supplied to the turntable 55 is circulated in the turntable 55 by the conduit pipe 57C provided in the turntable 55 to cool the turntable 55, that is, the substrate 15 mounted on the turntable 55. The conduit pipe 57C provided in the turntable 55 is preferably formed so that the supplied air is transported to the neighborhood of the upper surface of the turntable 55 adjacent to the substrate 15, whereby the substrate 15 is effectively cooled by the supplied air.

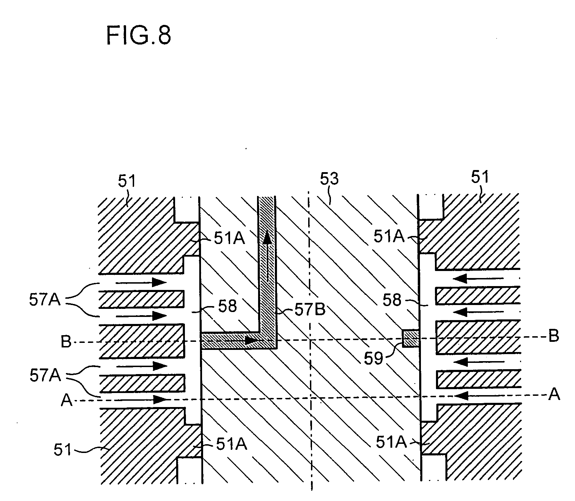

The structure of introducing air from the bearing 51 to the spindle 53 will be described in detail with reference to Figs. 8 to 10. Fig. 8 is a cross-sectional view showing the detailed structures of the bearing 51 and the spindle 53. As shown in Fig. 8, the conduit pipe 57A provided in the bearing 51 is divided into plural feeding ports, for example, and intercommunicates with a gap portion (gap) 58 provided between the bearing 51 and the spindle 53. More specifically, the gap 58 is formed so as to be spaced from the spindle 53 by about several µm, and it acts as an air bearing and also as an air in-take gap for introducing air into the conduit pipe 57B provided in the spindle 53. The bearing 51 is provided with a bearing projecting portion 51A that is spaced from the spindle 53 to the extent (for example, 1-2 µm) that gas (air) in the in-take gap 58 does not leak and surrounds the gap 58. That is, the area of the gap 58 is compartmented by the bearing projecting portion 51A.

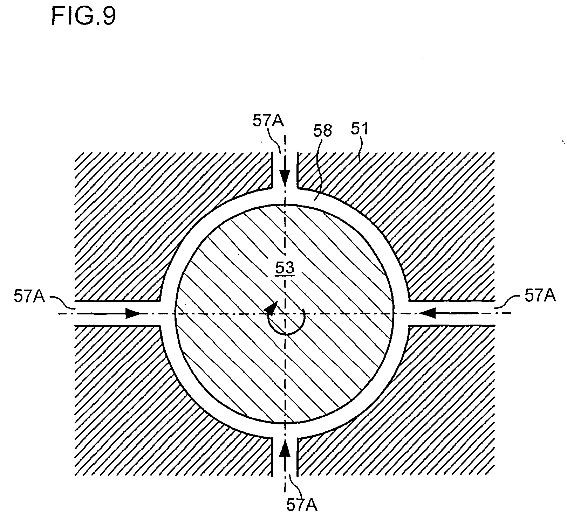

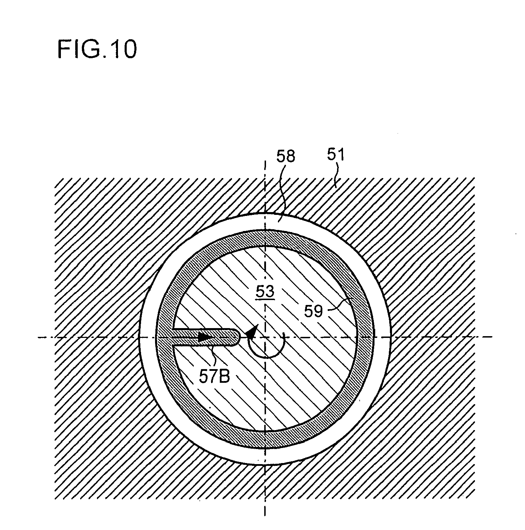

Figs. 9 and 10 are cross-sectional views showing the structures taken along line A-A and line B-B in Fig. 8. As shown in Fig. 9, air is introduced from the conduit pipe 57A in the bearing 51 into the gap 58 between the spindle 53 having a cylindrical shape and the bearing 51. As shown in Figs. 8 and 9, an annular groove 59 for introducing air into the conduit pipe 57B is formed at the outer peripheral portion of the spindle 53. Furthermore, the groove 59 is formed to be connected to the conduit pipe 57B. Accordingly, the air introduced in the gap 58 is taken into the conduit pipe 57B in the spindle 53 through the groove 59. The air taken into the conduit pipe 57B is supplied to the turntable 55 and circulated through the conduit pipe 57C in the turntable 55, thereby cooling the substrate 15 mounted on the turntable 55. According to the above-described configuration, the reaction of the resist during execution of the drawing (exposure) operation is suppressed, so that PED can be sufficiently suppressed.

Accordingly, the fluid (air) for the bearing 51 can be used for cooling, so that it is unnecessary to particularly provide a supply/discharge device, a route, etc. for fluid for cooling the substrate, and the configuration of the cooling device can be simplified. Furthermore, it is sufficient only to cool the substrate 15 and thus it is unnecessary to perform complicated and bothersome adjustment. In the foregoing description, an air bearing is used as the bearing, however, gas other than air or fluid may be used.

### [Fifth Embodiment]

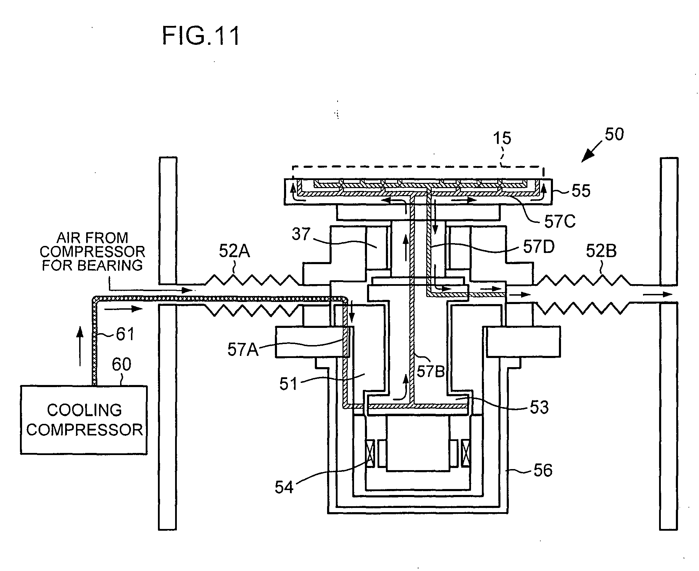

Fig. 11 is a block diagram showing the configuration of the substrate rotating portion of the electron beam exposure device 10 according to a fifth embodiment of the present invention. In the embodiment, an introducing/discharging passage for fluid (air) for cooling is provided separately from the fluid passage for the bearing as in the case of the fourth embodiment described above.

More specifically, a cooling compressor 60 and a conduit pipe 61 for feeding cooling air are provided. The conduit 61 is connected to the cooling compressor 60 and the conduit pipe 57A. the cooling air from the cooling compressor 60 is passed through the conduit pipe 61, supplied to the conduit 57A in the bearing 51 and taken into the conduit pipe 57B in the spindle 53. According to the above configuration, the reaction of the resist during execution of the drawing (exposure) operation on the substrate 15 can be suppressed and thus PED can be sufficiently suppressed.

As the case of the embodiment 4, the cooling medium is not limited to air, and other gas and liquid may be sued.

Accordingly, in the embodiment, another cooling passage which is different from the fluid (air) passage for the bearing 51 is provided in the bearing 51, the spindle 53 and the turntable 55, and the substrate 15 mounted on the turntable 55 is cooled by the cooling medium passing through the another cooling passage. In the embodiment, as in the case of the fourth embodiment, the cooling conduits are provided in the bearing 51, the spindle 53 and the turntable 55, and thus the configuration of the cooling device can be simplified unlike a case where the cooling passage is provided at the outside of the bearing 51.

### [Sixth Embodiment]

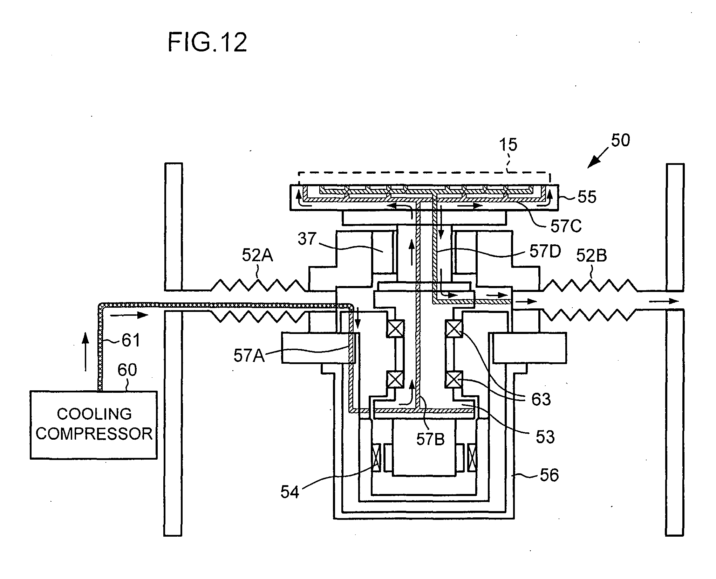

Fig. 12 is a block diagram showing the configuration of the substrate rotating portion of the electron beam exposure device 10 according to a sixth embodiment of the present invention. In the embodiment, a bearing portion and a cooling fluid supply portion are constructed independently of each other. That is, the bearing portion is not necessarily limited to the air bearing, and it may be other types of bearing such as a rolling bearing, a sliding bearing or the like. Fig. 12 shows a case where the bearing portion is constructed by a rolling bearing 63. The cooling fluid supply portion has a rotary joint structure, however, it may have another structure which can supply fluid to the rotating portion. The other configuration is the same as the fifth embodiment.

More specifically, the cooling air from the cooling compressor 60 is passed through the conduit pipe 61, and taken into the conduit pipe 57B in the spindle 53. According to the above configuration, the reaction of the resist during execution of the drawing (exposure) operation can be suppressed, and PED can be sufficiently suppressed.

As the case of the above-described embodiments, the cooling medium is not limited to air, and other gas or liquid may be used.

Accordingly, when it is unnecessary to use the air bearing as the bearing portion, the device can be constructed more easily.

### [Seventh Embodiment]

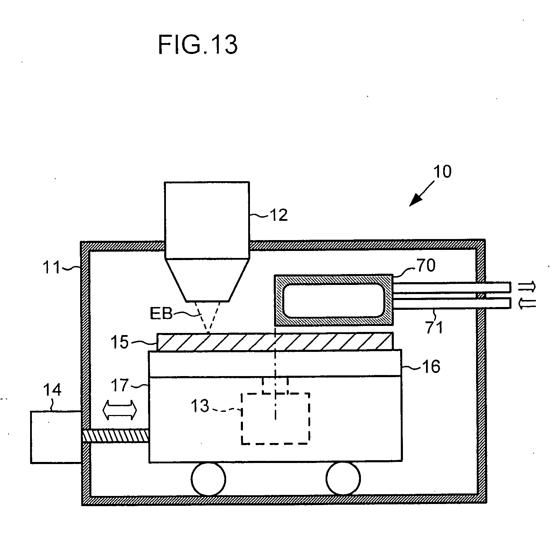

Fig. 13 is a diagram showing the configuration of the electron beam exposure device 10 according to a seventh embodiment of the present invention. The electron beam exposure device 10 is provided with a vacuum chamber 11, an electron beam column 12, a rotating device 13 and a feeding device 14 for rotating and feeding the substrate 15 disposed in the vacuum chamber 11, various circuits for performing the operation control of the substrate, the electron beam control, etc., and a control system (not shown).

In the embodiment, a low temperature member 70 for cooling the substrate 15 and a conduit pipe 71 for supplying cooling medium to the low temperature member 70.

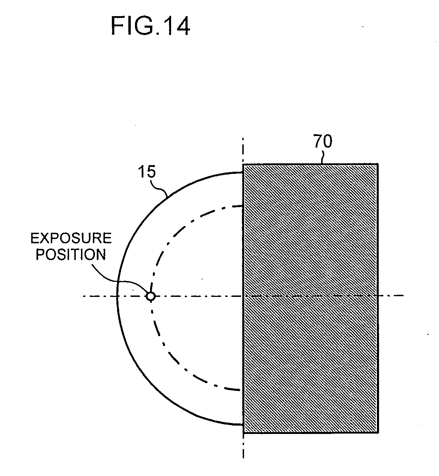

Fig. 14 is a top view showing the arrangement of the substrate 15 and the low temperature member 70. Specifically, the low temperature member 70 is disposed so as to be opposed to the exposure position (beam irradiation position) on the substrate 15 (i.e. , at the opposite side by 180 degrees). That is, by disposing the low temperature member 70 at a position different from the exposure position, the exposed portion is cooled by rotation of the substrate 15 after the exposure. That is, the heat of the substrate 15 (exposed resist portion) can be actively deprived by balance of radiation heat, whereby PED can be effectively suppressed.

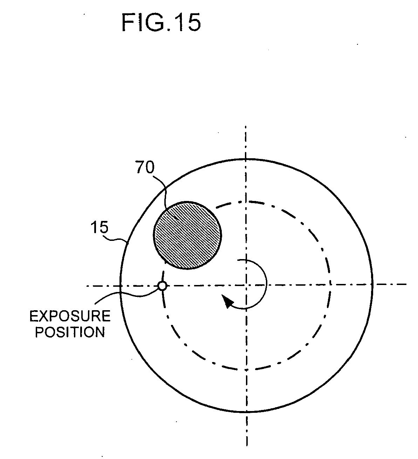

Fig. 15 is a top view showing the arrangement of the substrate 15 and the low temperature member 70. Specifically, the low temperature member 70 is disposed at the downstream side of the rotation of the substrate with respect to the exposure position on the substrate 15. According to this configuration, the heat of the substrate 15 (exposed resist portion) can be actively deprived by the balance of the radiation heat, whereby PED can be effectively suppressed.

In the foregoing description, an electron beam is used as an exposure beam, however, it may be applied to an exposure device using an optical beam such as a laser beam or the like. Furthermore, in an exposure device using synchrotron radiation (SOR) light or the like, the principal surface of the substrate 15 is disposed in the vertical direction (that is, the rotational axis is set to the horizontal direction), and in such a case, the low temperature member 70 may be disposed at the exposure surface side of the substrate.

### [Description of the Reference Numerals and Signs]

- 10, 30, 40: exposure device
- 15: Substrate
- 17, 33: Stage
- 18, 41: Cooling device
- 42: Temperature sensor
- 43: Temperature signal generator
- 44: Position detector
- 45: Temperature controller
- EB: Electron beam
- 51: Bearing
- 53: Spindle
- 55: Turntable
- 57A, 57B, 57C, 57D: Conduit pipe
- 63: Rolling bearing
- 70: Low temperature member

## Claims

1. An exposure device for irradiating an exposure beam to a substrate having a resist formed thereon to form a latent image on the resist, comprising:
a substrate holding portion for holding the substrate;
a driving portion for varying an irradiation position of the exposure beam relatively to the substrate; and
a cooling portion for cooling the substrate during irradiation of the exposure beam.

2. The exposure device according to claim 1, further comprising: an irradiation position detector for detecting the irradiation position of the exposure beam; a temperature detector for detecting the temperature at the irradiation position; and a temperature controller for controlling the temperature of the irradiation position on the basis of the temperature detected by the temperature detector.

3. The exposure device according to claim 1, wherein the substrate is mounted on the substrate holding portion and the cooling portion is a cooling pipe provided in the substrate holding portion.

4. The exposure device according to any one of claims 1 to 3, wherein the exposure beam is an electron beam.

5. The exposure device according to claim 1, wherein the resist is a chemical amplification resist.

6. The exposure device according to claim 1, wherein the exposure beam is a light beam, and the cooling portion is a cooling device.

7. An exposure device for irradiating an exposure beam to a substrate having a resist formed thereon, comprising:
a substrate mount portion for holding the substrate;
a spindle for rotating the substrate mount portion;
a fluid bearing portion for holding the spindle; and
a conduit pipe for supplying cooling fluid through the fluid bearing portion and the spindle to the substrate mount portion.

8. The exposure device according to claim 7, wherein the spindle has a groove portion through which the cooling fluid supplied through the fluid bearing portion is taken into the conduit pipe provided in the spindle.

9. The exposure device according to claim 7, further comprising a cooling fluid supply portion and a cooling fluid supply conduit pipe for supplying cooling fluid from the cooling fluid supply portion to the conduit pipe provided in the spindle.

10. An exposure device for irradiating an exposure beam to a substrate having a resist formed thereon, comprising:
a substrate mount portion for holding the substrate;
a spindle for rotating the substrate mount portion;
a bearing portion for holding the spindle, and
a cooling fluid supply portion and a cooling fluid supply conduit pipe, provided independently of the bearing portion, for supplying cooling fluid from the cooling fluid supply portion to a conduit pipe provided in the spindle.

11. An exposure device for irradiating an exposure beam to a disc-shaped substrate having a resist formed thereon to form a latent image on the resist, comprising:
a substrate mount portion for holding the substrate and rotating the substrate;
an irradiating portion for irradiating the exposure beam to the substrate; and
a low temperature member that is disposed at the exposure surface side of the substrate and at the rotational downstream side of the irradiation position of the exposure beam.

12. The exposure device according to claim 11, wherein the low temperature member is disposed at the exposure surface side of the substrate and at the opposite side to the irradiation position with respect to the center of the substrate.
